# EUROPEAN PATENT APPLICATION

(11) **EP 4 570 501 A1**
(43) Date of publication of application: **18.06.2025**
(21) Application number: 24218427.3
(22) Date of filing: 09.12.2024
(51) Int. Cl.: B33Y 80/00, H01L 23/538, H05K 3/12, B29L 31/30

(54) **SYSTEMS AND METHODS FOR INTEGRATION OF ELECTRONIC CIRCUIT SYSTEMS INTO AN AIRCRAFT STRUCTURE**

(30) Priority: 11.12.2023 IN 202341084332; 04.03.2024 US 202418595074
(71) Applicant: Goodrich Lighting Systems, Inc., Phoenix, AZ 85040-1169 (US)
(72) Inventor: PATHUPILLIATH, Suresh, 678101 Palakkad (IN)
(74) Representative: Dehns

(57) **Abstract**

A method for manufacturing an aircraft structure includes additively manufacturing a body portion (320) defining a first cavity and a second cavity (328). The method further includes disposing electronic components (341, 342) in the first and second cavities. The method further includes additively manufacturing a pathway layer over the electronic components, the pathway layer defines a channel (344) extending between and to the first electronic component and the second electronic component. The method further includes additively manufacturing a conductive pathway (329) in the channel to extend between and to the first electronic component and the second electronic component, whereby the first electronic component is electrically coupled to the second electronic component.

## Description

### CROSS-REFERENCE TO RELATED APPLICATIONS

This application claims priority to, and the benefit of, India Provisional Patent Application No. 202341084332, filed December 11, 2023 and titled "SYSTEMS AND METHODS FOR INTEGRATION OF ELECTRONIC CIRCUIT SYSTEMS INTO AN AIRCRAFT STRUCTURE," and US application 18/595074 filed 4 March 2024. FIELD

The present disclosure relates generally to structures with integrated electric circuitry for aircraft and to methods for manufacturing aircraft structures with integrated electronics.

### BACKGROUND

Typical aircraft include various electronics, sometimes arranged as one or more printed circuit boards, that are connected together with a multitude of wires that are routed along structural aircraft components. The printed circuit boards and the associated wiring are typically mounted to existing structural components to secure these electronic components to the aircraft.

For example, common passenger aircraft include a fuselage that holds a passenger cabin including the passenger seats, the hand luggage compartments, the sanitary facilities and so on. The inside of such a passenger cabin is usually separated from the fuselage, the skin, and other structural parts of the aircraft by a lining with a plurality of lining panels adjoining one another. The passenger cabin is supplied by a data and power infrastructure that is primarily comprised of electrical wiring and corresponding connectors that are often placed between the aircraft structure and the lining panels, such that the electric infrastructure is 'hidden' from the passengers. Specifically, a multitude of wires may be arranged in cable bundles, each wire being solidly formed with a circular profile that is surrounded by an insulation. The cable bundles may be anchored within fixed locations using brackets or similar holding components that in turn may be attached to the lining panels. Typically, strict requirements are put on the functionality, on the temperature and humidity resistance, as well as on the general safety precautions of such an electric infrastructure. Consequently, a strong focus is particularly placed on the robustness of the power and data cabling.

### SUMMARY

Generally disclosed herein is a method for manufacturing an aircraft structure in accordance with various embodiments. The method includes additively manufacturing a first plurality of layers of a body portion of the aircraft structure, wherein the first plurality of layers of the body portion include a top layer defining a first cavity and a second cavity. The method further includes disposing a first electronic component in the first cavity and disposing a second electronic component in the second cavity. The method further includes additively manufacturing a pathway layer over the top layer, the pathway layer defines a channel extending between and to the first electronic component and the second electronic component. The method further includes additively manufacturing a conductive pathway in the channel to extend between and to the first electronic component and the second electronic component, whereby the first electronic component is electrically coupled to the second electronic component.

These and other embodiments can include one or more of the following. The method can further include additively manufacturing a finishing layer over the conductive pathway. The finishing layer and the first plurality of layers can be made of the same material. The top layer of the first plurality of layers can be an insulating layer. The method can further include disposing an insulating layer over the conductive pathway, prior to additively manufacturing the finishing layer over the conductive pathway. The finishing layer and the first plurality of layers can be made of the same material, and the conductive pathway is made of a conductive metal material. The first plurality of layers can be made of a first conductive material, the top layer can be made of an insulating material, and the conductive pathway can be made of a second conductive material.

Another method for manufacturing an aircraft structure includes designing an aircraft structure including a structural body and an integrated circuit, identifying a plurality of layers of the aircraft structure, identifying a material for each of the layers of the aircraft structure, printing a first non-conductive material layer to define a plurality of cavities, curing the non-conductive material layer, disposing an electronic component in each cavity of the plurality of cavities, printing a second non-conductive material layer over the first non-conductive material layer to define a channel extending between and to at least a first electronic component and a second electronic component, printing a conductive material in the channel to form an electronic connection between the first electronic component and the second electronic component, and printing a third non-conductive material layer over the second non-conductive material layer and over the conductive material to insulate the conductive material.

In various embodiments, the method further includes printing a base portion of the aircraft structure, upon which the first non-conductive material layer is printed. The first non-conductive material layer, the second non-conductive material layer, and the third non-conductive material layer can be made of the same non-conductive material. The first non-conductive material layer, the second non-conductive material layer, and the third non-conductive material layer can encapsulate the electronic components and the electronic connection. The channel and the electronic component can be located in different layers of the aircraft structure from one another. The integrated circuit can be substantially flush with an outer surface of the structural body. The integrated circuit can be embedded beneath an outer surface of the structural body. The step of printing the first non-conductive material layer to define the plurality of cavities can include printing the first non-conductive material layer over a conductive material layer of the structural body. The conductive material layer of the structural body can be made of a first conductive material, and the electronic connection can be made of a second conductive material that is different from the first conductive material. The method can further include printing a plurality of conductive material layers to encapsulate the first non-conductive material layer, the second non-conductive material layer, and the third non-conductive material layer.

An aircraft structure is disclosed herein. The aircraft includes a structural body portion and an integrated circuit. The integrated circuit includes a first electronic component embedded in a first layer of the structural body portion, a second electronic component embedded in the first layer of the structural body portion, and a conductive pathway extending between and to the first electronic component and the second electronic component, and the conductive pathway is embedded in a second layer of the structural body portion.

In various embodiments, the aircraft structure further includes a connector embedded in the structural body portion, whereby the integrated circuit can be electrically connected to an external electronic component. In various embodiments, the aircraft structure further includes an insulating material disposed between the conductive pathway and the structure body portion, wherein the insulating material is formed using a first additive manufacturing process and the structural body portion is formed using a second additive manufacturing process.

The foregoing features and elements may be combined in any combination, without exclusivity, unless expressly indicated herein otherwise. These features and elements as well as the operation of the disclosed embodiments will become more apparent in light of the following description and accompanying drawings.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the following detailed description and claims in connection with the following drawings. While the drawings illustrate various embodiments employing the principles described herein, the drawings do not limit the scope of the claims.
FIG. 1A is a schematic view of an aircraft component having integrated electronic components, in accordance with various embodiments;
FIG. 1B is a section view of the aircraft component of FIG. 1A having integrated electronic components embedded beneath an outer surface of a structural body portion, in accordance with various embodiments;
FIG. 1C is a section view of the aircraft component of FIG. 1A having integrated electronic components embedded flush with an outer surface of a structural body portion, in accordance with various embodiments;
FIG. 2 is a flow chart for a method for additive manufacturing of an aircraft component having integrated electronic components, in accordance with various embodiments; and
FIG. 3A, FIG. 3B, FIG. 3C, FIG. 3D, FIG. 3E, FIG. 3F, FIG. 3G, FIG. 3H, FIG. 3I, and FIG. 3J are schematic views of an additive manufacturing process of an aircraft component having integrated electronic components, in accordance with various embodiments.

### DETAILED DESCRIPTION

The detailed description of exemplary embodiments herein makes reference to the accompanying drawings, which show exemplary embodiments by way of illustration. While these exemplary embodiments are described in sufficient detail to enable those skilled in the art to practice the exemplary embodiments of the disclosure, it should be understood that other embodiments may be realized and that logical changes and adaptations in design and construction may be made in accordance with this disclosure and the teachings herein. Thus, the detailed description herein is presented for purposes of illustration only and not limitation. The steps recited in any of the method or process descriptions may be executed in any order and are not necessarily limited to the order presented.

Furthermore, any reference to singular includes plural embodiments, and any reference to more than one component or step may include a singular embodiment or step. Also, any reference to attached, fixed, connected or the like may include permanent, removable, temporary, partial, full and/or any other possible attachment option.

Surface lines may be used throughout the figures to denote different parts but not necessarily to denote the same or different materials. Throughout the present disclosure, like reference numbers denote like elements. Accordingly, elements with like element numbering may be shown in the figures, but may not necessarily be repeated herein for the sake of clarity.

The systems and methods disclosed herein may find particular use in connection with aircraft. However, various aspects of the disclosed systems and methods may be adapted for performance in a variety of other vehicles or systems, for example, spacecraft, trains, cars, trucks, boats, submarines, machinery, among others. As such, numerous applications of the present disclosure may be realized.

Apparatuses, systems, and methods of the present disclosure include additively manufacturing aircraft structures with an electrical system embedded on to the structure thereof. Additive manufacturing (also referred to as 3D printing in some instances) provides extraordinary design freedom and hence it is widely used for manufacturing with multiple applications in engineering, construction, industrial design, automotive industries, and aerospace industries. Among various advantages, it offers the possibility to integrally form functional and structural elements into components, which otherwise-within conventional manufacturing-would necessarily require elaborate installation efforts.

Aspects of the present disclosure provide lightweight solutions for the data and power transmission infrastructure of an aircraft structure offering simple manufacture and installation. A method of manufacturing an aircraft structure with integrated electronic components includes using an additive manufacturing process (also referred to as 3D printing in some cases) to form the electric lines and associated electronic components on or into the aircraft component.

Aspects of the present disclosure permit a structural component to be additively manufactured with integrated electronics, thereby reducing the weight and footprint of the system. For example, the weight of structural components with integrated electronics manufactured using the additive manufacturing method described herein can be reduced by between 20% and 60% compared to equivalent structural components and external electronics coupled together using traditional methods. Aspects of the present disclosure advantageously replace individual electric wires, cable routes or bundles, cable connectors and similar components of an electrical infrastructure of an aircraft (e.g., within the passenger cabin or other structures located externally from the passenger cabin, such as the wings, stabilizers, etc.) by integrating electronic connections directly into the aircraft structure in a (multi-material) printing process. By using additive manufacturing, even complexly structured electric connections and/or circuitry can be manufactured directly on or in the aircraft structures in cost and time efficient production manner. Electronics integrated structures manufactured using the methods of the present disclosure can fitted directly into an aircraft interior structure or aircraft structure, reducing the manufacturing and/or assembly process, gaining more space compared to traditional systems, and reducing weight. Manufacturing methods of the present disclosure can reduce water consumption during manufacturing. Manufacturing methods of the present disclosure, in various embodiments, eliminate the need for a separate chassis, bracket, and/or cover which are traditionally used for the system to assemble in aircraft. Aircraft structures (e.g., lining panels, wing spars, etc.) according to the present disclosure can either replace and/or complement conventional aircraft structures.

In various embodiments, the integrated circuit is partially or fully integrated into a panel body, e.g., such that the electronic components are placed flush with or substantially flush with a surface of the aircraft structure, or are embedded beneath a surface of the aircraft structure, which may be advantageous as the electronic components lie protected within the structural body. In addition, electric insulation of the electronic components may be provided, e.g., directly in the printing process.

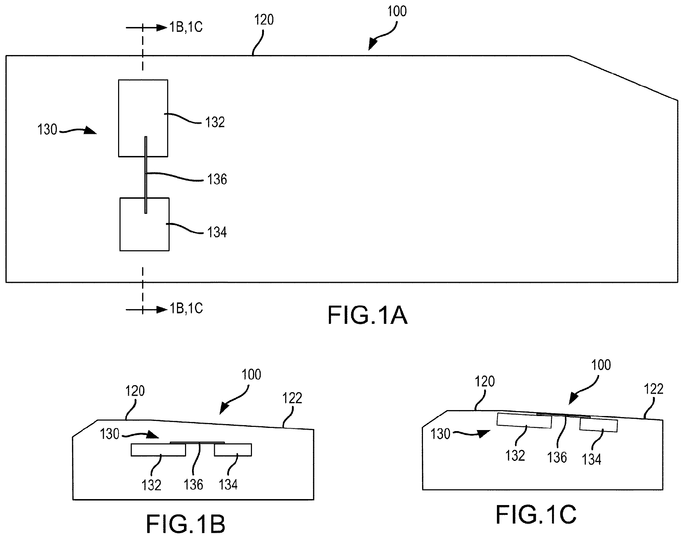

FIG. 1A illustrates a schematic view of an exemplary structural component 100 having a structural body portion 120 and an integrated circuit 130, in accordance with various embodiments. The integrated circuit 130 can include various electronic components, such as a first electronic component 132 and a second electronic component 134, connected together in a circuit by one or more conductive pathways, such as a conductive pathway 136. Although illustrated as having two electronic components 132, 134 and one conductive pathway 136, any number of electronic components and/or conductive pathways can be formed using the additive manufacturing method disclosed herein.

As an example only, structural component 100 can be an aircraft component. The structural component 100 can be a spar for a wing, a bulkhead, a stringer, a former, or any other structural component configured to carry flight loads and/or the weight of the aircraft while on the ground. The structural component 100 can be an aircraft interior panel, in accordance with various embodiments.

The integrated circuit 130 can include electronic components and conductive pathways to connect the components (e.g., interior lights, wing tip lights, environment monitoring systems, harnesses running in the aircraft) and other systems. First electronic component 132 and/or second electronic component 134 can be a passive electronic (e.g., a resistor, a capacitor, an inductor, a diode, a crystal, a relay, etc.), an active electronic device (e.g., a transistor, an integrated circuit, etc.), or any other suitable electronic device that would be desirable to integrate into the structure of the body portion 120.

Conductive pathway 136 can be a conductive trace, a wire, a bus bar, or any other suitable conductive pathway. In various embodiments, the conductive pathway 136 is made of a conductive metal, such as silver, copper, gold, or alloys of the same among others.

The structural component 100 (i.e., the structural body portion 120 and the integrated circuit 130) can be manufactured using one or more additive manufacturing processes. As used herein, the term "additive manufacturing" encompasses any method or process whereby a three-dimensional object is produced by creation of a substrate or material to an object, such as by addition of successive layers of a material to an object to produce a manufactured product having an increased mass or bulk at the end of the additive manufacturing process than the beginning of the process. In contrast, traditional manufacturing (e.g., forms of subtractive manufacturing) by machining or tooling typically relies on material removal or subtractive processes, such as cutting, lathing, drilling, grinding, and/or the like, to produce a final manufactured object that has a decreased mass or bulk relative to the starting workpiece. Other traditional manufacturing methods includes forging or casting, such as investment casting, which utilizes the steps of creating a form, making a mold of the form, and casting or forging a material (such as metal) using the mold. As used herein, the term "additive manufacturing" should not be construed to encompass fabrication or joining of previously formed objects.

A variety of additive manufacturing technologies are commercially available. Such technologies include, for example, fused deposition modeling, polyjet 3D printing, electron beam freeform fabrication, direct metal laser sintering, electron-beam melting, selective laser melting, selective heat sintering, selective laser sintering, stereolithography, multiphoton photopolymerization, and digital light processing. These technologies may use a variety of materials as substrates for an additive manufacturing process, including various plastics and polymers, metals and metal alloys, ceramic materials, metal clays, organic materials, and the like. Any method of additive manufacturing and associated compatible materials, whether presently available or yet to be developed, are intended to be included within the scope of the present disclosure.

FIG. 1B is a section view of the structural component 100 of FIG. 1A. The integrated circuit 130 can be embedded beneath an outer surface 122 of the body portion 120, in accordance with various embodiments. However, the integrated circuit 130 can also be embedded flush, or substantially flush, with the outer surface 122 of the body portion 120, as illustrated in FIG. 1C.

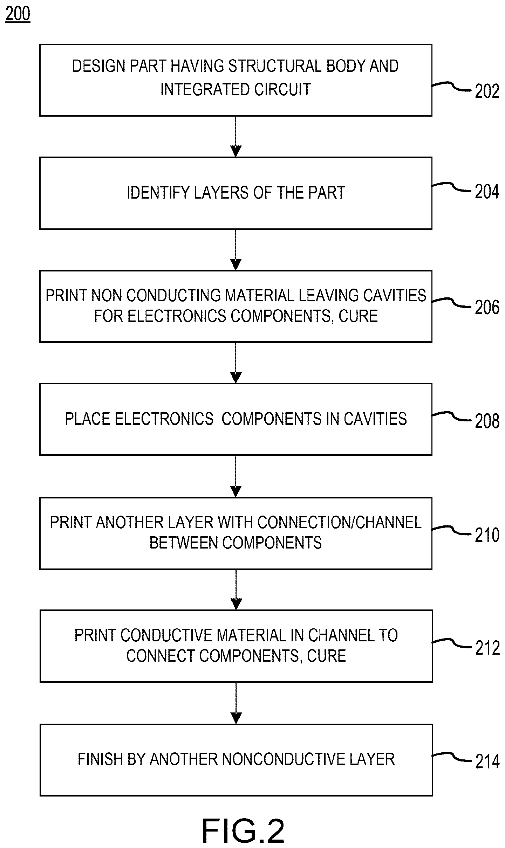

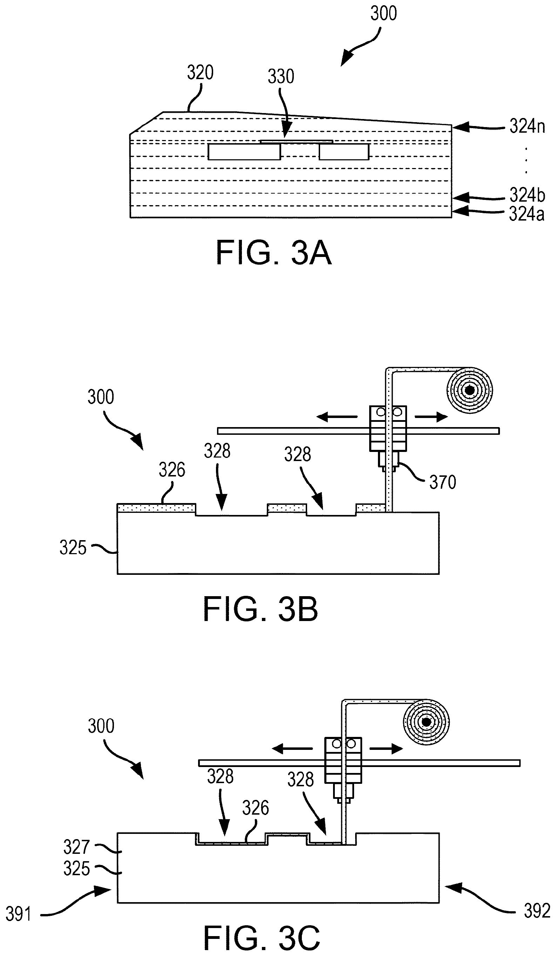

FIG. 2 illustrates a flowchart for a method 200, in accordance with various embodiments. In various embodiments, the method 200 is a method for manufacturing an aircraft structure with integrated electronic components. For ease of description, the method 200 is described below with reference to FIG. 3A through FIG. 3J. The method 200 of the present disclosure, however, is not limited to use of the exemplary aircraft component 300 of FIG. 3A through FIG. 3J.

In step 202, the method 200 includes designing an aircraft part or component 300 having a structural body 320 and integrated electronic components 330. In various embodiments, the aircraft component 300 is similar to the structural component 100 of FIG. 1A and FIG. 1B. The aircraft component 300 can be designed using a computer-aided design (CAD) program.

In step 204, the method 200 includes identifying layers (e.g., layer 324a through layer 324n) of the aircraft component 300 (see FIG. 3A). In various embodiments, the layers of the aircraft component 300 can be identified using a computer-aided design (CAD) program, such as an additive manufacturing/3D printing software. The location and thickness of each layer can depend on the additive manufacturing technique(s) being used, the geometry of the aircraft component 300, and the materials being used, among other factors. In various embodiments, each layer is oriented horizontally with respect to the orientation of the aircraft component 300 as it is being printed.

In step 206, the method 200 includes printing a non-conductive, or insulating, material 326 (e.g., glass, ceramic, or polymers such as plastic, polytetrafluoroethylene, etc.) that leaves and/or defines a space (e.g., cavities 328) for a plurality of electronic components (e.g., electronic component and electronic component). If the main body portion 325 is made of a non-conductive material 326, the electronic components can be placed directly onto the main body portion 325, for example as illustrated in FIG. 3B. If the main body portion 325 is made of a conductive material 327, the non-conductive material 326 can be printed over the conductive material 327 at the locations where the electronic components are to be installed, for example as illustrated in FIG. 3C. Accordingly, the non-conductive material 326 can define the cavities 328.

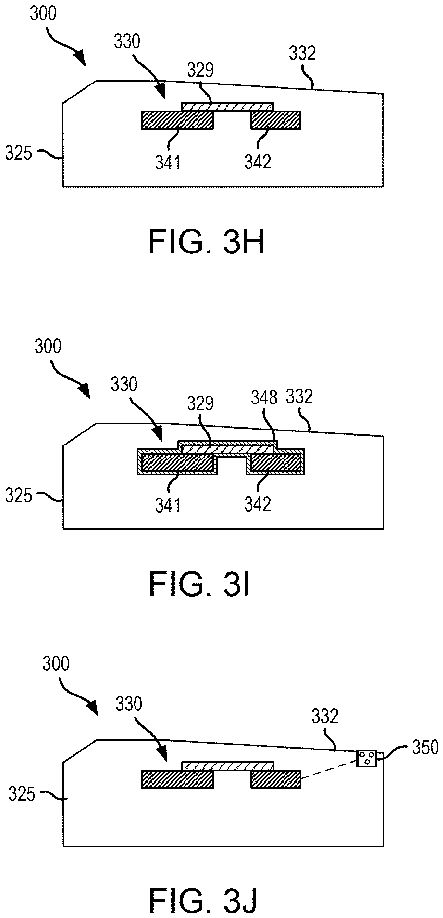

In various embodiments, the non-conductive material 326 layer is spaced apart from a first side 391 of the main body portion 325 and a second side 392 of the main body portion 325. Stated differently, the non-conductive material 326 may not span across the entire part and may be encapsulated within the main body portion 325 such that no part of the non-conductive material 326 is exposed to an external surface of the aircraft component 300 after the manufacturing process is finished (e.g., see FIG. 3I).

Each layer can be cured while or after the layer is printed, depending on the additive manufacturing process being used. For example, for material extrusion (as illustrated), a first layer is built as a nozzle 370 deposits material where desired onto the cross-sectional area of the first (and subsequent) layer(s). Additional layers are added on top of previous layers. Layers are fused together upon deposition as the material is in a melted state. The material cures as it cools or decreases in temperature.

Other additive manufacturing methods include powder bed fusion where a layer, typically 0.1mm thick, of material is spread over the build platform. A laser fuses the first layer or first cross section of the part. A new layer of powder is spread across the previous layer using a roller. Further layers or cross sections are fused and added. The process repeats until the entire part is created. These and other additive manufacturing processes are within the knowledge of those skilled in the art and are not described in detail herein for brevity.

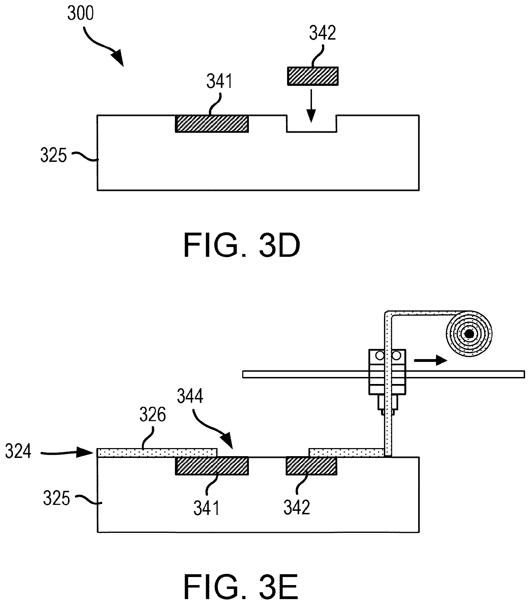

In step 208, the method 200 includes placing the electronic components (e.g., electronic component 341 and electronic component 342) into the cavities 328 (see FIG. 3D). The electronic components can be placed manually by hand or using an automated process, for example using a machine such as a robot.

In step 210, the method 200 includes printing an additional layer 324 above the electronic components 341, 342 to define a connection or channel 344 extending between and to the electronic components 341, 342 (e.g., see FIG. 3E). If the main body portion 325 is made of a non-conductive material 326, the channel 344 can define the channel 344 directly. If the main body portion 325 is made of a conductive material 327, the non-conductive material 326 can be printed over the conductive material 327 at the locations where the channel 344 is formed, so as to insulate the subsequent conductive pathway from the main body portion 325, for example similar to the process illustrated in FIG. 3C.

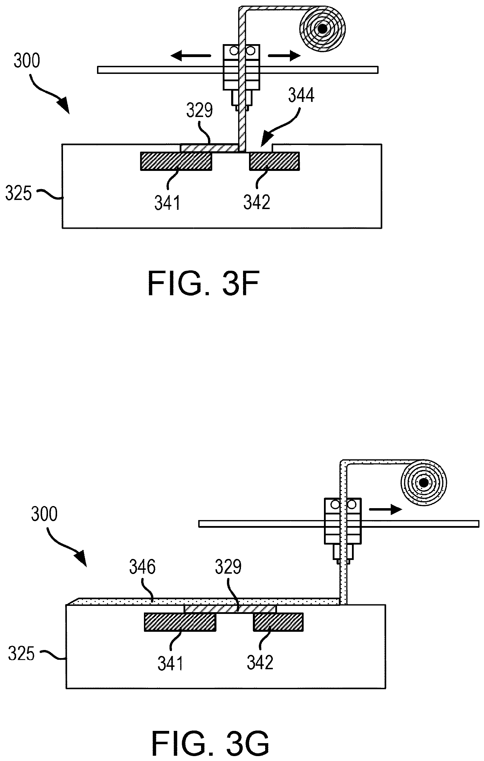

In step 212, and with particular focus on FIG. 3F, the method 200 includes printing a conductive material 329 within the channel 344 to connect the electronic components (e.g., electronic component 341 and electronic component 342). Accordingly, the conductive material 329 can extend within a single plane or layer; though it is contemplated that the conductive material 329 can be printed as a plurality of sub-layers, depending on the desired thickness of the conductive layer and the printing thickness of the conductive material. The conductive material 329 can be copper, aluminum, silver, gold, nickel, stainless steel, iron, or alloys thereof, or any other suitable conductive material for using as a conductive layer for transferring data and/or power signals. The conductive material 329 can extend between and to the first electronic component 341 (and particularly a connection point thereof) and the second electronic component 342 (and particularly a connection point thereof). The conductive material 329 can be printed in a layer located directly above the first electronic component 341 and the second electronic component 342. In various embodiments, the conductive material 329 is printed directly on top of, and in contact with, connection points of the first electronic component 341 and the second electronic component 342.

In step 214, and with particular focus on FIG. 3G, the method 200 includes printing another non-conductive layer 346 over the conductive material 329. Accordingly, the conductive material 329 can be insulated from the rest of the main body portion 325. In various embodiments, particularly where the main body portion 325 is made of a non-conductive material, the main body portion 325 and the non-conductive layer 346 can be made of the same material. However, particularly when the main body portion 325 is made of a conductive material, the non-conductive material of the non-conductive layer 346 is different from the conductive material of the main body portion 325.

In various embodiments, FIG. 3H illustrates the finished aircraft component 300 with the electronic components 330 embedded below an outer surface 332 of the aircraft component 300; though in various embodiments, the electronic components 330, or component thereof, can be substantially flush with the outer surface 332, for example as illustrated in FIG. 1C.

FIG. 3I shows the finished aircraft component 300 with an insulating layer 348 insulating the electronic components 330 from the main body portion 325. In various embodiments, the insulating layer 348 is embedded below the outer surface 332 of the aircraft component 300; though in various embodiments, the insulating layer 348 can be substantially flush with the outer surface 332, for example similar to the embodiment illustrated in FIG. 1C.

In various embodiments, the main body portion 325 (which can be made of a first plurality of layers) can be made of a first conductive material (e.g., aluminum, steel, etc.). The insulating layer 348 can be made of an insulating material. The conductive material 329 (also referred to herein as a conductive pathway) can be made of a second conductive material (e.g., copper, silver, etc.). In various embodiments, the main body portion 325 and the insulating layer 348 are made of the same insulating material; though in various embodiments the main body portion 325 and the insulating layer 348 are made of two or more different insulating materials.

FIG. 3J shows a plug or connector 350 embedded in the main body portion 325 and in electronic communication with the electronic components 330, whereby the electronic components 330 can be electrically coupled with other electronic components located externally from the aircraft component 300. The connector 350 can be embedded in the main body portion 325 during the additive manufacturing process.

After the aircraft component is additively manufactured, as described herein, the part can be installed to the aircraft assembly for further installation/integration into the overall aircraft assembly. Aircraft components manufactured using the additive manufacturing method disclosed herein can be integrated with electronic components without losing the strength and other chemical and physical properties of the part. Because the electronics are integrated into the part, separate part or support structure is not needed to house the system, but rather the system will be part of the structure or part to be fitted on to the overall system or structure of the aircraft. Additive manufacturing methods of the present disclosure tend to reduce the process time for product development and manufacturing.

Benefits and other advantages have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, and any elements that may cause any benefit or advantage to occur or become more pronounced are not to be construed as critical, required, or essential features or elements of the disclosure. The scope of the disclosure is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C.

Systems, methods, and apparatus are provided herein. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments falling within the scope of the claims.

## Claims

1. A method for manufacturing an aircraft structure, comprising:
additively manufacturing a first plurality of layers of a body portion (325) of the aircraft structure, wherein the first plurality of layers of the body portion include a top layer defining a first cavity and a second cavity;
disposing a first electronic component (330) in the first cavity and disposing a second electronic component in the second cavity;
additively manufacturing a pathway layer over the top layer, the pathway layer defines a channel (344) extending between and to the first electronic component and the second electronic component; and
additively manufacturing a conductive pathway (136) in the channel to extend between and to the first electronic component and the second electronic component, whereby the first electronic component is electrically coupled to the second electronic component.

2. The method of claim 1, further comprising additively manufacturing a finishing layer over the conductive pathway, and optionally wherein the finishing layer and the first plurality of layers are made of the same material, or wherein the finishing layer and the first plurality of layers are made of the same material, and the conductive pathway is made of a conductive metal material.

3. The method of claim 1 or 2, wherein the top layer of the first plurality of layers is an electrically insulating layer.

4. The method of claim 2, further comprising disposing an insulating layer over the conductive pathway, prior to additively manufacturing the finishing layer over the conductive pathway.

5. The method of claim 1, wherein the first plurality of layers are made of a first conductive material, the top layer is made of an insulating material, and the conductive pathway is made of a second conductive material.

6. A method for manufacturing an aircraft structure, comprising:
designing the aircraft structure including a structural body (320) and an integrated circuit (330);
identifying a plurality of layers of the aircraft structure;
identifying a material for each of the layers in the plurality of layers of the aircraft structure;
printing a first non-conductive material layer to define a plurality of cavities (328);
curing the first non-conductive material layer;
disposing an electronic component in each cavity of the plurality of cavities;
printing a second non-conductive material layer over the first non-conductive material layer to define a channel (344) extending between and to at least a first electronic component and a second electronic component;
printing a conductive material in the channel to form an electronic connection between
the first electronic component and the second electronic component; and printing a third non-conductive material layer over the second non-conductive material
layer and over the conductive material to insulate the conductive material.

7. The method of claim 6, further comprising printing a base portion of the aircraft structure, upon which the first non-conductive material layer is printed.

8. The method of claim 6 or 7, wherein the first non-conductive material layer, the second non-conductive material layer, and the third non-conductive material layer are made of the same non-conductive material.

9. The method of claim 6, 7 or 8, wherein the first non-conductive material layer, the second non-conductive material layer, and the third non-conductive material layer encapsulate the first and second electronic components and the electronic connection.

10. The method of any of claims 6 to 9, wherein the channel and the electronic component are located in different layers of the aircraft structure from one another.

11. The method of any of claims 6 to 10, wherein the integrated circuit is substantially flush with an outer surface of the structural body, or wherein the integrated circuit is embedded beneath an outer surface of the structural body.

12. The method of any of claims 6 to 11, wherein printing the first non-conductive material layer to define the plurality of cavities includes printing the first non-conductive material layer over a conductive material layer of the structural body, and optionally wherein the conductive material layer of the structural body is made of a first conductive material, and the electronic connection is made of a second conductive material.

13. The method of claim 6, further comprising printing a plurality of conductive material layers to encapsulate the first non-conductive material layer, the second non-conductive material layer, and the third non-conductive material layer.

14. An aircraft structure comprising:
a structural body portion (320); and
an integrated circuit (330), comprising:
a first electronic component embedded in a first layer of the structural body portion;
a second electronic component embedded in the first layer of the structural body portion; and
a conductive pathway (136) extending between and to the first electronic component and the second electronic component, and the conductive pathway is embedded in a second layer of the structural body portion.

15. The aircraft structure of claim 14, further comprising a connector (350) embedded in the structural body portion, whereby the integrated circuit can be electrically connected to an external electronic component, and/or further comprising an insulating material (326) disposed between the conductive pathway and the structure body portion, wherein the insulating material is formed using a first additive manufacturing process and the structural body portion is formed using a second additive manufacturing process.
